# EUROPÄISCHE PATENTSCHRIFT

(11) **EP 2 834 862 B1**
(45) Veröffentlichungstag und Bekanntmachung des Hinweises auf die Patenterteilung: **11.03.2020**
(21) Anmeldenummer: 13714900.1
(22) Anmeldetag: 02.04.2013
(51) Int. Cl.: H01L 51/52, H01L 27/32

(54) **LICHTABGABEVORRICHTUNG MIT EINEM OLED-ELEMENT**
LIGHT-EMISSION DEVICE WITH AN OLED ELEMENT
DISPOSITIF ÉMETTEUR DE LUMIÈRE COMPRENANT UN ÉLÉMENT OLED

(30) Priorität: 05.04.2012 DE 102012205625
(43) Veröffentlichungstag der Anmeldung: 11.02.2015
(73) Patentinhaber: Tridonic GmbH & Co KG, 6851 Dornbirn (AT)
(72) Erfinder: RICHTER, Lucien, 01309 Dresden (DE); AMELUNG, Jörg, 01099 Dresden (DE); ERITT, Michael, 01129 Dresden (DE); KIRCHHOF, Christian, 01099 Dresden (DE)
(74) Vertreter: Thun, Clemens
(86) Internationale Anmeldenummer: PCT/EP2013/056897
(87) Internationale Veröffentlichungsnummer: WO 2013/150003

(56) Entgegenhaltungen:
- EP-A1- 2 293 358
- EP-A1- 2 613 371
- EP-A2- 2 221 900
- US-A1- 2006 284 557
- US-A1- 2010 148 665
- US-A1- 2011 156 084

## Beschreibung

Die Erfindung betrifft eine Lichtabgabevorrichtung mit einem flächigen OLED-Element (OLED: organische lichtemittierende Diode; organic light emitting diode) und einem Verkapselungselement zum Schutz des OLED-Elements.

Auf der Basis vom OLEDs können neuartige Lichtabgabevorrichtungen bzw. Leuchtelemente verwirklicht werden. Als flächige Leuchtkörper, die im Vergleich zu anorganischen LEDs (LED: light emitting diode) eine moderatere Leuchtdichte aufweisen, sind OLEDs besonders geeignet für die Herstellung flächiger diffuser Lichtquellen, wie beispielsweise Leuchtpanels. Großflächige, diffus abstrahlende Lichtquellen sind insbesondere für Anwendungen in der allgemeinen Beleuchtung erwünscht, womit OLEDs ein vielversprechendes Zukunftspotenzial für diese Anwendungsgebiete haben. In Folge der verwendeten Dünnschichttechnologie bei der Herstellung von OLEDs kann es ferner möglich werden, flexible Leuchtkörper zu realisieren, die bisher nicht bekannte Möglichkeiten zur Beleuchtung von Räumen eröffnen.

Ein OLED-Element weist zwei flächig ausgebildete Elektroden auf, zwischen denen eine "aktive" bzw. organische Schicht aus organischen Materialien eingebettet ist. Bei Anlegen einer geeigneten Spannung bzw. Einprägen eines geeigneten Stroms wird von der aktiven organischen Schicht Licht emittiert. Mindestens eine der beiden Elektroden ist dabei transparent, um eine Abgabe des erzeugten Lichts durch diese Elektrode hindurch nach außen zu ermöglichen.

Für praktische Anwendungen, insbesondere in der allgemeinen Beleuchtung, sind möglichst gleichmäßig leuchtende OLEDs, d. h. OLEDs, die über ihre Abstrahlfläche möglichst gleichmäßig Licht abgeben, erwünscht bzw. gefordert. Analog zu anorganischen LEDs sind OLEDs strombetriebene Bauelemente. Dies bedeutet, dass die Leuchtdichte einer OLED mit dem durch die lichtemittierende, aktive Schicht der OLED fließenden Strom korreliert ist. Zur Realisierung gleichmäßig leuchtender OLEDs ist daher innerhalb der lichtemittierenden Schicht eine über die flächige Ausdehnung der OLED homogene Stromdichte erforderlich. Dies ist bei der Herstellung entsprechend großflächiger OLED-Elemente jedoch problematisch.

Die transparente Elektrode kann beispielsweise mittels eines transparenten leitfähigen Oxids (TCO: transparent conductive oxide) oder mittels durchsichtiger Metallschichten realisiert sein. Die elektrische Leitfähigkeit dieser transparenten Elektrodenmaterialien ist vergleichsweise gering und somit der Spannungsabfall innerhalb der Elektrode nicht zu vernachlässigen. Aufgrund der Strom-Spannungscharakteristik einer OLED wirken sich geringe Spannungsunterschiede innerhalb einer Elektrodenfläche als wahrzunehmende, unerwünschte Helligkeitsunterschiede aus.

In einem konkreten Beispiel kann bei einem OLED-Element als transparente Elektrode Indium-Zinn-Oxid (ITO: indium tin oxide) mit einer Schichtdicke von ca. 100 nm verwendet werden, wobei die ITO-Schicht auf ein Substrat, insbesondere ein Glassubstrat aufgebracht wird und als Anode dienen kann. Darauf folgt die organische bzw. aktive Schicht, die mehrere Unter-Schichten aufweisen kann, mit einer Schichtdicke von insgesamt ca. 100 bis 200 nm. Abschließend wird eine metallene Kathode, die beispielsweise Aluminium aufweisen kann, mit einer Schichtdicke von ca. 100 bis 500 nm Dicke aufgebracht. Bei entsprechend großflächigen OLED-Elementen kann der hochohmige Widerstand der ITO-Schicht Werte von 10 oder 20 Ohm/square erreichen. Dabei ist zu bedenken, dass eine elektrische Kontaktierung der ITO-Schicht mit Bezug auf ihre insgesamt flächige Form nur vom Randbereich her möglich ist.

Zum Schutz eines so aufgebauten OLED-Elements ist es weiterhin bekannt, ein Verkapselungselement vorzusehen, das die beiden Elektroden und die organische Zwischenschicht überdeckend angeordnet ist und das sich an den seitlichen Rändern bis zum Glassubstrat hin erstreckt.

Neben einem geringen effektiven Flächenwiderstand der transparenten Elektrode ist für eine gleichmäßig strahlende OLED also insbesondere eine möglichst gleichmäßige Stromeinspeisung notwendig. Um nun die Homogenität der Leuchtdichteverteilung des abgestrahlten Lichts über die flächige Ausdehnung der OLED zu verbessern, sind über den seitlichen Randbereich des OLED-Elements verteilt häufig mehrere Einspeisepunkte für den Betriebsstrom vorgesehen, d. h. es befinden sich an einer bzw. beiden Elektroden randseitig mehrere elektrische Kontaktierungsbereiche, über die die Elektroden elektrisch kontaktiert sind.

Typischerweise wird dabei eine möglichst symmetrische Kontaktierung des OLED-Elements angestrebt. Insbesondere die Anode weist in der Regel mehrere Kontaktierungsbereiche auf, da diese im Allgemeinen eine geringere Leitfähigkeit aufweist als die Kathode. Es kann aber auch vorgesehen sein, dass die Kathode oder beide Elektroden, Anode und Kathode, mehrere Kontaktierungsbereiche aufweisen, über die der Betriebsstrom zu- bzw. abfließt.

Aus der EP 2 293 358 A1 ist eine Elektrolumineszenzlampe bekannt, bei der eine Elektrolumineszenz-Folie zwischen zwei Kunststoffplatten angeordnet ist. Eine der beiden Kunststoffplatten weist eine Ausnehmung auf, durch die hindurch eine Kontaktierung der Elektrolumineszenz-Folie mittels Federkontakten vorgesehen ist.

Aus der EP 2 221 900 A2 ist ein organisches Elektrolumineszenz-Modul bekannt, bei dem zur Kontaktierung der Anode ein Kontaktelement vorgesehen ist, das mit einem wellenförmigen Abschnitt die Anode kontaktiert. Das Modul ist in einem Gehäuse angeordnet, wobei zwischen dem wellenförmigen Abschnitt und der GehäuseInnenwand ist ein Elastomer angeordnet ist.

Weitere Elektrolumineszenz-Anordnungen sind aus den Schriften US 2010/0148665 A1, US 2006/0284557 A1 und US 2011/0156084 A1 bekannt.

Ferner zeigt die EP 2 613 371 A1 ein Verfahren zum Herstellen eines flächigen LED-Elements, wobei mittels elastischer Bond-Drähte eine Kontaktierung des LED-Elements vorgenommen wird.

Der Erfindung liegt die Aufgabe zugrunde, eine entsprechende verbesserte Lichtabgabevorrichtung anzugeben. Insbesondere soll die Lichtabgabevorrichtung verbesserte mechanische und elektrische Eigenschaften aufweisen.

Diese Aufgabe wird mit dem in dem unabhängigen Anspruch genannten Gegenstand gelöst. Besondere Ausführungsarten der Erfindung sind in den abhängigen Ansprüchen angegeben.

Gemäß der Erfindung ist eine Lichtabgabevorrichtung nach Anspruch 1 vorgesehen.

Durch die Verwendung des Trägers lässt sich besonders geeignet eine Stromzufuhr zu dem OLED-Element an mehreren seitlichen Randgebieten des OLED-Elements realisieren. Hierdurch ist eine besonders homogene Stromzufuhr zu dem OLED-Element ermöglicht. Dabei kann das Leiterelement aufgrund seiner elastischen Eigenschaft unter Gewährleistung einer zuverlässigen elektrischen Kontaktierung mechanische Spannungen aufnehmen. Somit lässt sich die Gefahr verringern oder gar vermeiden, dass die elektrische Verbindung zwischen dem Träger und dem OLED-Element durch Kräfte, die bei einer Handhabung der Lichtabgabevorrichtung auftreten können oder die durch Temperaturschwankungen entstehen können, nachteilig beeinflusst bzw. beeinträchtigt wird. Auf diese Weise werden die elektrischen und mechanischen Eigenschaften der Lichtabgabevorrichtung verbessert. Ferner lässt sich das OLED-Element geeignet so gestalten, dass es eine besonders große lichtabgebende Fläche aufweist.

Vorzugsweise ist der elektrische Kontaktbereich für die erste Elektrode des OLED-Elements - normal zu dem OLED-Element betrachtet - länglich, wobei das elektrische Leiterelement elektrisch leitend mit dem Kontaktbereich verbunden ist. Auf diese Weise lässt sich erzielen, dass der Spannungsabfall an dem Kontaktbereich besonders klein ist und der Stromeintrag besonders homogen. Hierdurch wird in der Folge eine besonders homogene Lichtabgabe des OLED-Elements ermöglicht.

Weiterhin vorzugsweise ist das Verkapselungselement - normal zu dem OLED-Element betrachtet - zumindest in erster Näherung rechteckförmig, so dass es dementsprechend vier Seiten aufweist, wobei der elektrische Kontaktbereich derart ausgebildet ist, dass er sich längs einer der vier Seiten über wenigstens ein Viertel, vorzugsweise über wenigstens ein Drittel der Länge dieser einen Seite erstreckt. Hierdurch ist weitergehend ein besonders homogener Stromeintrag in das OLED-Element ermöglicht.

Weiterhin vorteilhaft mit Bezug auf einen besonders homogenen Stromeintrag weist die Lichtabgabevorrichtung außerdem wenigstens einen weiteren Kontaktbereich für die erste Elektrode auf, der analog zu dem zuerst genannten Kontaktbereich für die erste Elektrode gestaltet und angeordnet ist.

Entsprechend vorteilhaft weist die Lichtabgabevorrichtung außerdem einen zweiten elektrischen Kontaktbereich für eine zweite Elektrode des OELD-Elements auf, wobei der zweite Kontaktbereich analog zu dem Kontaktbereich für die erste Elektrode gestaltet und angeordnet ist.

Eine besonders gute elektrische Verbindung zwischen dem Träger und dem OLED-Element lässt sich erzielen, wenn das elektrische Leiterelement aus Metall besteht oder metallisiert ist. Vorteilhaft besteht das elektrische Leiterelement aus einer Metallfolie oder einem Metalldraht oder aus einer flexiblen Leiterplatte. Insbesondere kann das elektrische Leiterelement aus Kupfer oder Aluminium oder einer Legierung aus bzw. mit Kupfer und/oder Aluminium bestehen.

Vorteilhaft ist das elektrische Leiterelement über wenigstens eine Fügestelle, vorzugsweise über mehrere Fügestellen mit dem Kontaktbereich für eine erste Elektrode und/oder mit einem auf dem Träger gebildeten Träger-Kontaktbereich elektrisch verbunden. Weiterhin ist die wenigstens eine Fügestelle dabei durch Löten oder Kleben, insbesondere mit einem anisotropen Klebstoff oder einem Leitklebstoff, gebildet. Hierdurch ist eine besonders zuverlässige elektrische Kontaktierung ermöglicht.

Eine besonders geeignete Elastizität des elektrischen Leiterelements lässt sich erzielen, wenn das Leiterelement länglich ist und in einem Längsabschnitt eine 180°-Biegung aufweist. Insbesondere kann das elektrische Leiterelement spiralförmig oder wellenförmig sein.

Die Erfindung wird im Folgenden anhand von Ausführungsbeispielen und mit Bezug auf die Zeichnungen näher erläutert. Es zeigen:
- Fig. 1: eine Skizze eines Querschnitts durch eine erfindungsgemäße Lichtabgabevorrichtung gemäß einem ersten Ausführungsbeispiel,
- Fig. 2: eine Skizze einer Sicht auf eine Rückseite des OLED-Elements der Lichtabgabevorrichtung,
- Fig. 3: eine, der Fig. 1 entsprechende Skizze zu einem zweiten Ausführungsbeispiel und
- Fig. 4: eine entsprechende Skizze zu einem dritten Ausführungsbeispiel.

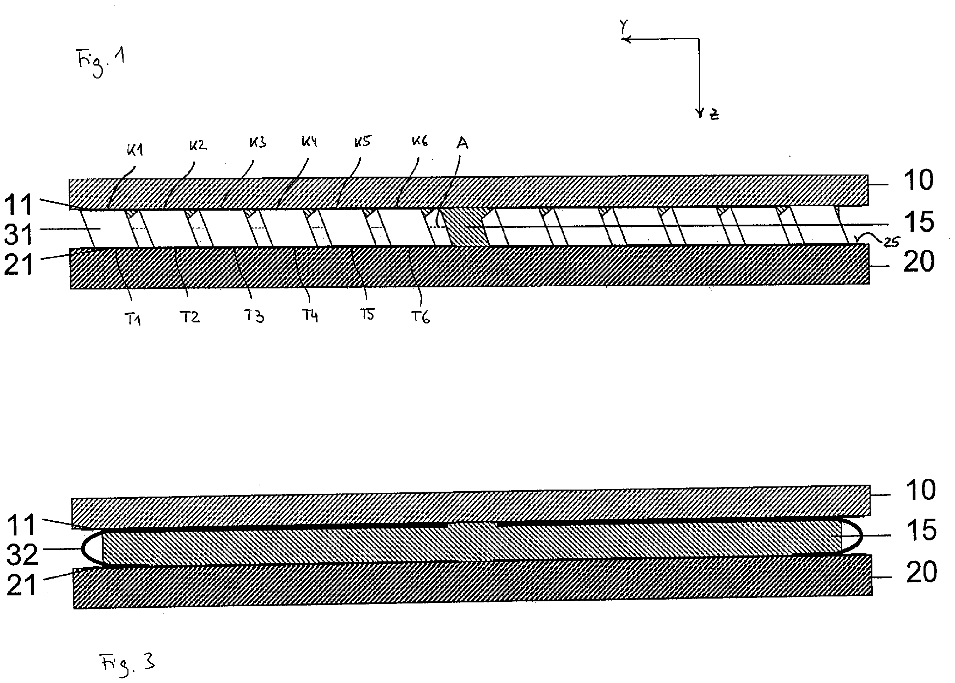

In Fig. 1 ist eine Skizze eines Querschnitts durch eine erfindungsgemäße Lichtabgabevorrichtung gezeigt. Die Lichtabgabevorrichtung umfasst ein OLED-Element, ein Verkapselungselement 15 und einen Träger 20.

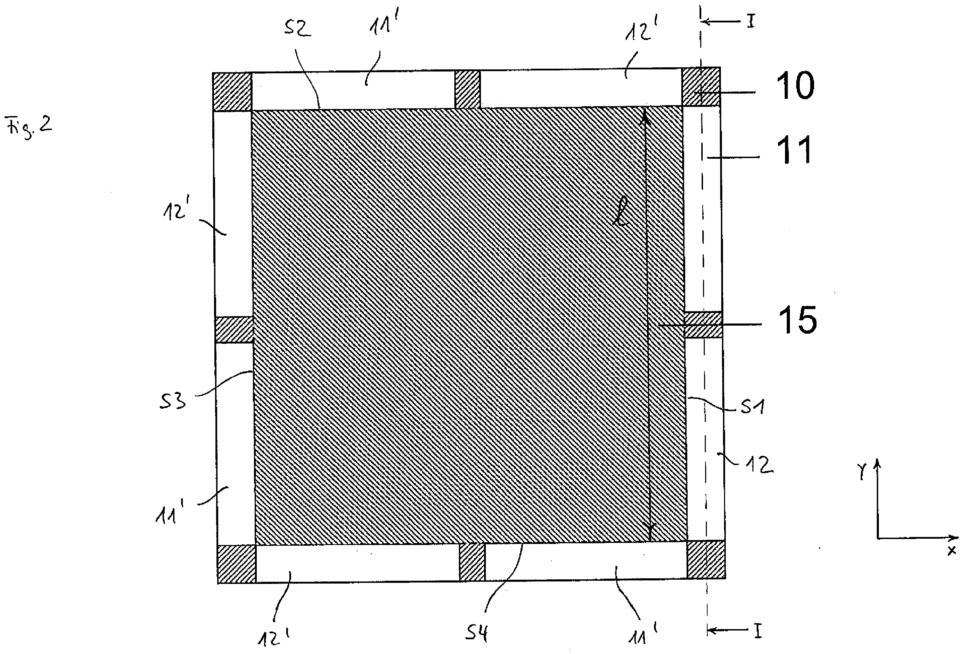

In Fig. 2 ist eine Sicht auf das OLED-Element und das Verkapselungselement 15 - ohne den Träger 20 - gezeigt. Zunächst wird anhand der Fig. 2 auf das OLED-Element und das Verkapselungselement 15 eingegangen.

Das OLED-Element ist derart geformt, dass es insgesamt flächig ist. Es weist also in eine erste Richtung x und in eine dazu rechtwinklig orientierte zweite Richtung *y* jeweils eine deutlich größere Erstreckung auf als in eine dritte Richtung z, die rechtwinklig zu der ersten Richtung x und rechtwinklig zu der zweiten Richtung *y* orientiert ist. Beispielsweise kann vorgesehen sein, dass die Erstreckung des OLED-Elements in Richtung z kleiner ist als ein Zehntel seiner Erstreckung in Richtung x und/oder seiner Erstreckung in Richtung y.

Durch die flächige Form des OLED-Elements lässt sich dementsprechend eine Ebene festlegen, in der das OLED-Element eine maximale Projektionsfläche aufweist - im gezeigten Beispiel also eine Ebene, die durch die Richtungen *x* und *y* aufgespannt ist. In Fig. 1 ist in diesem Sinne eine Sicht auf das OLED-Element normal zu dieser Ebene bzw. in (oder entgegen) der Richtung z gezeigt. Diese Richtung ist hier auch mit "normal zu dem OLED-Element" oder kurz "normal" bezeichnet.

Die Erstreckung des OLED-Elements in Richtung x kann - wie im gezeigten Beispiel der Fall - gleich groß sein wie seine Erstreckung in Richtung y, so dass es bei "normaler" Betrachtung eine quadratische Form aufweist. Es kann aber auch so gestaltet sein, dass es, entsprechend betrachtet, allgemein eine rechteckige Form oder auch eine anderweitige Form, beispielsweise eine hexagonale Form aufweist.

Das OLED-Element kann so groß sein, dass es - normal betrachtet - eine Fläche von mindestens 1 cm² aufweist, vorzugsweise von mindestens 10 cm², beispielsweise mindestens 20 cm².

Das OLED-Element kann wie eingangs beschrieben aufgebaut sein. Insbesondere kann es dementsprechend vier Schichten aufweisen und zwar - mit Bezug auf die Skizze der Fig. 1 von "hinten" nach "vorne" - ein Substrat 10, beispielsweise ein Glassubstrat, eine darauf angeordnete erste Elektrode, eine auf der ersten Elektrode angeordnete organische Schicht und eine auf der organischen Schicht angeordnete zweite Elektrode.

Das Verkapselungselement 15 ist kann insbesondere derart gestaltet, dass es sich über diejenige Elektrode erstreckt, die mit Bezug auf die organische Schicht dem Substrat 10 gegenüberliegt. Das Verkapselungselement 15 kann beispielsweise aus Glas gebildet sein. Es kann durch eine Folie gebildet sein.

Wie in Fig. 2 beispielhaft gezeigt, weist das Verkapselungselement 15 - normal betrachtet - eine kleinere Fläche auf als das Substrat 10, wobei es sich vollständig innerhalb der normalen Projektion des Substrats 10 befindet. Auf diese Weise kann es sich an allen seinen seitlichen Rändern bis zu dem Substrat 10 hin erstrecken und so die Elektroden und die organische Schicht besonders gut vor Umwelteinflüssen schützen.

Dementsprechend sind in der in Fig. 1 skizzierten Ansicht die beiden Elektroden und die organische Schicht von dem Verkapselungselement 15 verdeckt.

Das OLED-Element weist weiterhin einen elektrischen Kontaktbereich 11 für eine erste Elektrode, beispielsweise für die Anode auf. Vorzugsweise ist der Kontaktbereich 11 - normal betrachtet - länglich. Hierdurch lässt sich erzielen, dass der Stromeintrag in das OLED-Element zum Betrieb des OLED-Elements besonders gleichförmig ist und in der Folge die Lichtabgabe des OLED-Elements besonders homogen ist. Außerdem lässt sich durch die längliche Gestaltung eine Kontaktierung der ersten Elektrode mit einem besonders geringen Übergangswiderstand erzielen.

Wie im gezeigten Beispiel der Fall, ist - normal zu dem OLED-Element gesehen - der Kontaktbereich 11 neben dem Verkapselungselement 15 angeordnet.

Insbesondere ist der Kontaktbereich 11 - normal betrachtet - innerhalb der normalen Projektion des Substrats 10 aber außerhalb der normalen Projektion des Verkapselungselements 15 angeordnet. Vorzugsweise grenzt dabei der Kontaktbereich 11 so betrachtet mit einer seiner beiden Längsseiten unmittelbar an das Verkapselungselement 15. Durch diese Gestaltung lässt sich bei robuster Gestaltung des OLED-Elements eine besonders große lichtabgebende Fläche des OLED-Elements erzielen.

Das Verkapselungselement 15 weist, normal betrachtet, vorzugsweise dieselbe Form auf wie das Substrat 10, jedoch mit einer geringfügig kleineren Fläche. So lässt sich, insbesondere bei entsprechend konzentrischer Ausrichtung dieser beiden Teile, ein Randbereich auf dem Substrat 10 bilden, auf dem der Kontaktbereich 11 angeordnet ist.

Wie im gezeigten Beispiel der Fall, kann das Verkapselungselement 15 dementsprechend zumindest in erster Näherung rechteckförmig sein, so dass es dementsprechend vier Seiten *S1, S2, S3, S4* aufweist. Ein besonders guter Stromeintrag lässt sich erzielen, wenn der Kontaktbereich 11 derart ausgebildet ist, dass er sich längs einer der vier Seiten, hier der Seite *S1*, fast über die Hälfte der Länge *l* dieser Seite *S1* erstreckt. Beispielsweise kann die Gestaltung derart sein, dass sich der Kontaktbereich 11 über wenigstens ein Viertel, vorzugsweise über wenigstens ein Drittel der Länge *l* erstreckt.

Vorteilhaft weist das OLED-Element außerdem wenigstens einen weiteren Kontaktbereich 11' für die erste Elektrode auf, der analog zu dem zuerst genannten Kontaktbereich 11 für die erste Elektrode gestaltet und angeordnet ist, insbesondere an wenigstens einer weiteren der vier Seiten *S2, S3, S4* analog angeordnet ist. Insbesondere kann an jeder der drei weiteren Seiten *S2, S3, S4* jeweils ein entsprechend gestalteter weiterer Kontaktbereich 11' für die erste Elektrode angeordnet sein.

Für die zweite Elektrode bzw. die Kathode ist vorzugsweise die Gestaltung mit Bezug auf wenigstens einen Kontaktbereich 12 bzw. entsprechende weitere Kontaktbereiche 12' analog. Dabei sind die Kontaktbereiche 11, 11' für die erste Elektrode vorzugsweise alternierend mit den Kontaktbereichen 12, 12' für die zweite Elektrode angeordnet, insbesondere umlaufen am Rand des Verkapselungselements 15.

Wie gezeigt, sind vorteilhaft an jeder der vier Seiten *S1*, *S2, S3, S4* jeweils ein Kontaktbereich 11, 11' für die erste Elektrode und ein Kontaktbereich 12, 12' für die zweite Elektrode ausgebildet. Wenn dabei - wie in Fig. 2 beispielhaft gezeigt - die Gestaltung weiterhin derart ist, dass sich jeweils auf zwei gegenüberliegenden der vier Seiten *S1, S2, S3, S4* jeweils ein Kontaktbereich 11, 11' der ersten Elektrode und ein Kontaktbereich 12, 12' der zweiten Elektrode genau gegenüberliegen, lässt sich ein besonders homogener Stromeintrag in das OLED-Element verwirklichen.

Eine entsprechende Gestaltung mit Bezug auf die Kontaktbereiche für die beiden Elektroden kann beispielsweise auch bei entsprechender hexagonaler Form des Verkapselungselements 15 bzw. des OLED-Elements vorgesehen sein.

Der in Fig. 1 gezeigte Schnitt erstreckt sich - wie in Fig. 2 durch *I - I* angedeutet - normal zu der Richtung x und verläuft dabei durch den Kontaktbereich 11. Man erkennt in Fig. 2 das Substrat 10 des OLED-Elements, die weiteren einzelnen Schichten des OLED-Elements sind jedoch aus Gründen der Übersichtlichkeit nicht dargestellt. Weiterhin erkannt man den Kontaktbereich 11 und das Verkapselungselement 15.

Das OLED-Element ist also so auf dem Träger 20 angeordnet, dass das Verkapselungselement 15 zu dem Träger 20 weist. Der Träger 20 kann ebenfalls flächig gestaltet sein und dabei parallel zu dem OLED-Element ausgerichtet angeordnet sein. Bei dem Träger 20 kann es sich dabei beispielsweise um eine Trägerplatte handeln.

Der Träger 20 ist vorzugsweise derart gestaltet, dass er bei normaler Sicht auf das OLED-Element eine Fläche aufweist, die wenigstens so groß ist wie die Fläche des Verkapselungselements 15, vorzugsweise wenigstens so groß, wie die Fläche des OLED-Elements, wobei die Relativanordnung zwischen dem Träger 20 und dem OLED-Element derart ist, dass die normale Projektion des Verkapselungselements 15, vorzugsweise des OLED-Elements, vollständig innerhalb der normalen Projektion des Trägers 20 liegt oder maximal deckungsgleich mit Letzterer ist. Hierdurch ist ermöglicht, dass die Stromeinspeisung, ausgehend von dem Träger 20 von allen seitlichen Randgebieten des OLED-Elements her an Letzteres heran geführt ist, so dass die Stromeinspeisung besonders gleichförmig ist.

Der Träger 20 kann transparent sein oder nicht transparent sein. Beispielsweise kann der Träger 20 aus Glas, PMMA (Polymethylmethacrylat), PET (Polyethylenterephthalat), Metall oder Kunststoff bestehen. Beispielsweise kann der Träger 20 durch eine PET Folie gebildet sein.

Der Träger 20 kann eine Oberfläche 25 aufweisen, die zu dem OLED-Element weist und auf der zur Stromversorgung des OLED-Elements Leiterbahnen aufgebracht sind bzw. als PCB (printed circuit board) entsprechend ausgebildet sein. Insbesondere kann auf dem Träger 20, vorzugswiese auf der Oberfläche 25, ein Träger-Kontaktbereich 21 ausgebildet sein, der zur elektrische leitenden Verbindung mit dem OLED-Element ausgestaltet bzw. vorgesehen ist und der dementsprechend beispielsweise mit einer der Leiterbahnen elektrisch verbunden ist. Vorzugsweise ist auch der Träger-Kontaktbereich 21 länglich, vorzugsweise analog zu dem Kontaktbereich 11 für die erste Elektrode.

Insbesondere bei Verwendung einer Folie oder flexiblen PCB kann das OLED-Element flexibel gestaltet sein, so dass die Lichtabgabevorrichtung insgesamt flexibel gestaltet sein kann.

Weiterhin weist die Lichtabgabevorrichtung ein elektrisches Leiterelement 31 für eine elektrische Verbindung zwischen dem Träger 20 und dem OLED-Element 10 auf. Das elektrische Leiterelement 31 kann auf Seite des Trägers 20 dementsprechend insbesondere mit dem Träger-Kontaktbereich 21 elektrisch verbunden sein und auf Seite des OLED-Elements mit dem Kontaktbereich 11.

Das elektrische Leiterelement 31 ist derart gestaltet, dass es in einer Richtung normal zu dem OLED-Element 10 - hier in Richtung z - elastisch ist. Hierdurch wird erzielt, dass der elektrische Kontakt zwischen dem Leiterelement 31 und dem OLED-Element einerseits und dem Träger 20 andererseits auch im Fall einer mechanischen Beanspruchung der Lichtabgabevorrichtung oder einer durch Temperaturschwankungen bedingten Spannung zuverlässig erhalten bleibt.

Im hier gezeigten ersten Ausführungsbeispiel ist das elektrische Leiterelement 31 zur Erzielung der elastischen Eigenschaft spiralförmig gestaltet, insbesondere - wie gezeigt - so, dass sich das Leiterelement 31 längs einer zylindrischen, vorzugsweise kreiszylindrischen Spirale erstreckt. Die Orientierung des Leiterelements 31 ist dabei vorzugsweise derart, dass die - in Fig. 1 gepunktet angedeutete - Achse *A* der Spirale bzw. des Leiterelements 31 parallel zu der Längsachse des Kontaktbereichs 11 bzw. zu der Seite *S1* des Verkapselungselements 15 orientiert ist. Der Durchmesser des Leiterelements 31 normal zu dessen Achse A entspricht dabei zumindest im Wesentlichen dem Abstand zwischen dem Kontaktbereich 11 und dem Träger 20, so dass innerhalb einer Windung der Spirale jeweils eine Kontaktstelle an dem Kontaktbereich 11 und eine Kontaktstelle an dem Träger 20 gebildet ist.

Vorzugsweise weist das Leiterelement 31 mehrere Windungen auf, beispielsweise mindestens drei Windungen, so dass wenigstens jeweils drei Kontaktstellen an dem Kontaktbereich 11 einerseits und dem Träger 20 andererseits gebildet sind. Im gezeigten Beispiel weist das Leiterelement 31 sechs Windungen auf, so dass sechs Kontaktstellen *K1* ... *K6* an dem Kontaktbereich 11 gebildet sind und sechs Kontaktstellen *T1 ... T6* an dem Träger 20 bzw. an dem Träger-Kontaktbereich 21.

Das Leiterelement 31 erstreckt sich dabei zur Erzielung einer besonders homogenen Stromzufuhr vorzugsweise über wenigstens 80% der Länge des Kontaktbereichs 11.

Vorzugsweise ist das Leiterelement 31 metallen. Die Kontaktstellen *K1* ... *K6* sind vorzugsweise durch Fügetechnik gebildet bzw. sind Fügestellen. Die Fügestellen zwischen dem Leiterelement 31 und dem Kontaktbereich 11 sind beispielsweise durch Kleben, insbesondere mit einem Leitklebstoff oder einem anisotropen Klebstoff, gebildet. Die Fügestellen zwischen dem Leiterelement 31 und dem Träger 20 bzw. dem Träger-Kontaktbereich 21 sind beispielsweise durch Kleben, insbesondere mit einem Leitklebstoff oder einem anisotropen Klebstoff, oder durch Löten gebildet.

Die Kombination aus fester Verbindung mittels Fügetechnik mit dem in sich flexiblen Leiterelements 31 ermöglicht besonders geeignet eine Aufnahme mechanischer Spannungen, wie sie bei Temperaturänderungen bzw. mechanischer Beanspruchung der Lichtabgabevorrichtung auftreten können. Die Stromübertragung ist dabei zuverlässig gewährleistet. Die Gefahr einer Schädigung der festen Verbindungskontakte ist verhindert oder doch wenigstens deutlich verringert.

Vorzugsweise weist die Lichtabgabevorrichtung für jeden weiteren Kontaktbereich 11' für die erste Elektrode ein entsprechend gestaltetes weiteres Leiterelement auf.

Die elektrische Anbindung der zweiten Elektrode bzw. Kathode ist vorzugsweise analog vorgesehen.

Insbesondere ist die Gestaltung der Lichtabgabevorrichtung vorzugsweise auf allen vier Seiten *S1, S2, S3, S4* analog.

Hierdurch ist eine mehrseitige Einspeisung der Ströme in das OLED-Element 10 realisiert. Bei einer solchen mehrseitigen Einspeisung der Ströme in das OLED-Element 10 werden vorzugsweise über den Träger 20 die "Einzelverbindungen" für jeweils Anode und Kathode zusammengeführt. Dabei kann bei Bedarf mit einem zusätzlichen Vorwiderstand bzw. einer zusätzlichen Leiterbahnlänge die Stromführung so eingestellt werden, dass die organische Schicht des OLED-Elements so mit Strom versorgt wird, dass eine besonders homogene Ausleuchtung der Fläche bzw. Lichtabgabe erzielbar ist.

Durch eine entsprechend gewählte, geeignete Dimensionierung der Zuleitungen zu den einzelnen Anschlussflächen bzw. Kontaktierungsbereichen des Trägers 20 lässt sich ein eventuell vorhandener unterschiedlicher Stromverlauf auf dem Träger 20 kompensieren und so eine besonders gute Lichthomogenität des OLED-Elements erzielen.

Das metallene Leiterelement 31 ermöglicht auch eine sehr gute Stromleitung in Querrichtung bzw. in Richtung y; dies wäre durch Kontaktpads aufgrund der begrenzten Querleitfähigkeit alleine nicht gewährleistet.

In Fig. 3 ist eine der Fig. 1 entsprechende Skizze zu einem zweiten Ausführungsbeispiel gezeigt. Soweit nicht anders dargestellt, gelten die Ausführungen mit Bezug auf das erste Ausführungsbeispiel analog auch für das zweite Ausführungsbeispiel. Die Bezugszeichen sind analog gebraucht.

Bei dem zweiten Ausführungsbeispiel besteht das elektrische Leiterelement, hier mit 32 bezeichnet, aus einer dünnen, hochleitfähigen Metallfolie oder einem Metalldraht oder einer flexiblen Leiterplatte, z. B. aus Kupfer, Aluminium oder einer Legierung aus bzw. mit diesen Materialien. Die Stromeinspeisung auf dem OLED-Element 10 erfolgt dabei flächig, insbesondere durch einen länglich entlang des Kontaktierungsbereichs 11 ausgebildeten Kontakt zwischen dem Leiterelement 32 und dem Kontaktierungsbereich 11. Der Kontakt ist vorzugsweise wiederum durch Fügetechnik, z. B. mittels Leitklebstoff oder anisotropem Klebstoff gestaltet, so dass eine längliche Fügestelle gebildet ist. Die Fügestelle ist dabei vorteilhaft so groß gestaltet, dass sie sich über wenigstens 80% der Länge des Kontaktbereichs 11 erstreckt.

Der Kontaktierungsbereich 11 kann beispielsweise durch Dünn- oder Dickfilmtechnik gebildet sein. Durch entsprechende Fügetechnik lässt sich die vergleichsweise geringe Leitfähigkeit des Kontaktierungsbereichs 11 verstärken.

Auf Seite des Trägers 20 kann die Verbindung wiederum ebenfalls mittels entsprechender Fügetechnik (z. B. Löttechnik, Leitklebstoff, anisotroper Klebstoff) realisiert sein.

Die elektrische Verbindung der Kathode kann wiederum analog gebildet sein.

Das Leiterelement 32 kann beispielsweise metallen oder metallisiert sein.

Auch durch das Leiterelement 32 gemäß dem zweiten Ausführungsbeispiel ist eine besonders gute Kompensation von thermisch bedingten bzw. mechanischen Spannungen ermöglicht, die im Fall einer entsprechenden starren Verbindung zu einem Ausfall der Kontaktverbindung führen würde.

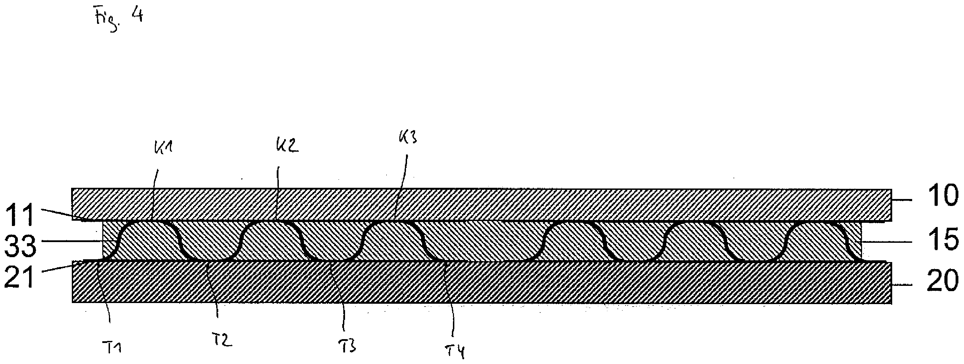

In Fig. 4 ist eine der Fig. 1 entsprechende Skizze zu einem dritten Ausführungsbeispiel gezeigt. Soweit nicht anders dargestellt, gelten die obigen Ausführungen analog auch für das dritte Ausführungsbeispiel. Die Bezugszeichen sind wiederum analog gebraucht.

Das elektrische Leiterelement, hier mit 33 bezeichnet, ist gemäß dem dritten Ausführungsbeispiel wellenförmig gestaltet, so dass - wie beim ersten Ausführungsbeispiel - mehrere Kontaktstellen, hier beispielhaft drei Kontaktstellen *K1* ... *K3* an dem Kontaktbereich 11 gebildet sind und mehrere Kontaktstellen, hier beispielhaft vier Kontaktstellen *T1 ... T4* an dem Träger 20 bzw. an dem Träger-Kontaktbereich 21.

Auf diese Weise wird wiederum eine "verteilte Kontaktierung" ermöglicht, die thermische Beanspruchungen bzw. mechanische Spannungen sehr gut kompensieren kann und eine langzeitstabile Verbindung ermöglicht.

Mit Bezug auf alle Ausführungsbeispiele lässt sich allgemeiner formulieren, dass das Leiterelement 31, 32, 33 zur Erzielung seiner elastischen Eigenschaft vorzugsweise länglich ist und dabei in wenigstens einem Längsabschnitt eine 180°-Biegung aufweist. Insbesondere ist dabei die Ausrichtung des Leiterelements 31, 32, 33 derart, dass die 180°-Biegung in einer, zu dem flächigen OLED-Element rechtwinklig orientierten Ebene gebildet ist. Im Fall des ersten Ausführungsbeispiels ist die 180°-Biegung in einer durch die Richtung x und die Richtung *z* aufgespannten Ebene ausgebildet, im Fall des zweiten Ausführungsbeispiels in einer durch die Richtung y und die Richtung z aufgespannten Ebene.

Durch die mehreren Kontakt- bzw. Fügestellen im Fall des ersten und dritten Ausführungsbeispiels bzw. eine entsprechend längliche Fügestelle im Fall des zweiten Ausführungsbeispiels lässt sich der Stromeintrag in das OLED-Element mit besonders wenig Verlust realisieren.

Das OLED-Element und/oder der Träger 20 und/oder Kontaktflächen können transparent oder opak ausgeführt sein.

Es kann auch vorgesehen sein, dass mehrere OLED-Elemente auf dem Träger 20 entsprechend angeordnet sind.

Die erfindungsgemäße Lichtabgabevorrichtung zeichnet sich insbesondere durch folgende Eigenschaften aus:
- Robuste Anbindung des OLED-Elements an den Träger
- Besonders Homogene Stromverteilung innerhalb des OLED-Elements zur Erzielung einer besonders homogenen Lichtabgabe
- Geringe Übergangswiderstände zwischen dem elektrischen Leiterelement und dem OLED-Element
- Hohe Effizienz der Lichtabgabevorrichtung

## Patentansprüche

1. Lichtabgabevorrichtung, aufweisend
- ein flächiges OLED-Element auf einem Substrat (10), wobei das OLED-Element eine auf dem Substrat (10) angeordnete erste Elektrode, eine auf der ersten Elektrode angeordnete organische Schicht und eine auf der organischen Schicht angeordnete zweite Elektrode aufweist, und
- ein Verkapselungselement (15) zum Schutz des OLED-Elements, wobei das Verkapselungselement (15) derart gestaltet ist, dass es sich über diejenige Elektrode erstreckt, die mit Bezug auf die organische Schicht dem Substrat (10) gegenüberliegt,
- einen Träger (20), auf dem das OLED-Element derart angeordnet ist, dass das Verkapselungselement (15) zu dem Träger (20) hin weist und
- ein elektrisches Leiterelement (31, 32, 33) für eine elektrische Verbindung zwischen dem Träger (20) und dem OLED-Element,
wobei das elektrische Leiterelement (31, 32, 33) in einer Richtung normal zu dem OLED-Element elastisch ist,
wobei der Träger (20) eine Oberfläche (25) aufweist, die zu dem OLED-Element weist und auf der zur Stromversorgung des OLED-Elements Leiterbahnen aufgebracht sind,
**dadurch gekennzeichnet,**
**dass** normal zu dem OLED-Element betrachtet
a) das Verkapselungselement (15) eine kleinere Fläche als das Substrat (10) aufweist und sich vollständig innerhalb der normalen Projektion des Substrats (10) befindet, und
b) ein elektrischer Kontaktbereich (11), der auf dem Substrat (10) und neben dem Verkapselungselement (15) angeordnet ist, wobei der elektrische Kontaktbereich (11) für eine erste Elektrode des OLED-Elements innerhalb der normalen Projektion des Substrats (10) aber außerhalb der normalen Projektion des Verkapselungselements (15) angeordnet ist.

2. Lichtabgabevorrichtung nach Anspruch 1,
wobei der elektrische Kontaktbereich (11) - normal zu dem OLED-Element betrachtet - länglich ist und wobei das elektrische Leiterelement (31, 32, 33) elektrisch leitend mit dem Kontaktbereich (11) verbunden ist.

3. Lichtabgabevorrichtung nach Anspruch 1 oder 2,
bei dem das Verkapselungselement (15) - normal zu dem OLED-Element betrachtet - zumindest in erster Näherung rechteckförmig ist, so dass es dementsprechend vier Seiten (*S1, S2, S3, S4*) aufweist und der elektrische Kontaktbereich (11) derart ausgebildet ist, dass er sich längs einer der vier Seiten (*S1*) über wenigstens ein Viertel, vorzugsweise über wenigstens ein Drittel der Länge (*l*) dieser einen Seite (*S1*) erstreckt.

4. Lichtabgabevorrichtung nach einem der Ansprüche 1 bis 3,
die wenigstens einen weiteren Kontaktbereich (11') für die erste Elektrode aufweist, wobei der weitere Kontaktbereich (11') derart ausgebildet ist, dass er sich längs einer der vier Seiten (S1) über wenigstens ein Viertel, vorzugsweise über wenigstens ein Drittel der Länge (l) dieser einen Seite (S1) erstreckt.

5. Lichtabgabevorrichtung nach einem der Ansprüche 1 bis 4,
die einen zweiten elektrischen Kontaktbereich (12) für eine zweite Elektrode des OLED-Elements aufweist, wobei der zweite Kontaktbereich (12) derart ausgebildet ist, dass er sich längs einer der vier Seiten (S1) über wenigstens ein Viertel, vorzugsweise über wenigstens ein Drittel der Länge (l) dieser einen Seite (S1) erstreckt.

6. Lichtabgabevorrichtung nach einem der vorhergehenden Ansprüche,
bei der das elektrische Leiterelement (31, 32, 33) aus Metall besteht oder metallisiert ist.

7. Lichtabgabevorrichtung nach einem der vorhergehenden Ansprüche,
bei der das elektrische Leiterelement (31, 32, 33) aus einer Metallfolie oder einem Metalldraht oder einer flexiblen Leiterplatte besteht.

8. Lichtabgabevorrichtung nach einem der vorhergehenden Ansprüche,
bei der das elektrische Leiterelement (31, 32, 33) aus Kupfer oder Aluminium oder einer Legierung aus bzw. mit Kupfer und/oder Aluminium besteht.

9. Lichtabgabevorrichtung nach einem der vorhergehenden Ansprüche,
bei der das elektrische Leiterelement (31, 32, 33) über wenigstens eine Fügestelle (*K1* ... *K6, T1 ... T6*), vorzugsweise über mehrere Fügestellen (*K1* ... *K6, T1 ... T6)* mit dem Kontaktbereich (11) für eine erste Elektrode und/oder mit einem auf dem Träger (20) gebildeten Träger-Kontaktbereich (21) elektrisch verbunden ist.

10. Lichtabgabevorrichtung nach Anspruch 9,
bei der die wenigstens eine Fügestelle (*K1* ... *K6, T1 ... T6*) durch Löten oder Kleben, insbesondere mit einem anisotropen Klebstoff oder einem Leitklebstoff, gebildet ist.

11. Lichtabgabevorrichtung nach einem der vorhergehenden Ansprüche,
bei der das elektrische Leiterelement (31, 32, 33) länglich ist und in einem Längsabschnitt eine 180°-Biegung aufweist.

12. Lichtabgabevorrichtung nach einem der vorhergehenden Ansprüche,
bei der das elektrische Leiterelement (31) spiralförmig ist.

13. Lichtabgabevorrichtung nach einem der vorhergehenden Ansprüche,
bei der das elektrische Leiterelement (33) wellenförmig ist.

## Claims

1. Light output device comprising
- a planar OLED element on a substrate (10), wherein the OLED element comprises a first electrode arranged on the substrate (10), an organic layer arranged on the first electrode and a second electrode arranged on the organic layer, and
- an encapsulation element (15) for protecting the OLED element, wherein the encapsulation element (15) is designed in such a way that it extends over the electrode that is opposite the substrate (10) with reference to the organic layer,
- a carrier (20) on which the OLED element is arranged in such a way that the encapsulation element (15) points to the carrier (20) and
- an electrical conductor element (31, 32, 33) for an electrical connection between the carrier (20) and the OLED element,
wherein the electrical conductor element (31, 32, 33) is elastic in a direction normal to the OLED element,
wherein the carrier (20) comprises a surface (25), which points to the OLED element and to which are applied conductor paths for the power supply of the OLED Element,
**characterized in that**
when viewed in the direction normal to the OLED element,
a) the encapsulation element (15) has a smaller surface than the substrate (10) and is completely within the normal projection of the substrate (10), and
b) an electrical contact region (11) arranged on the substrate (10) and next to the encapsulation element (15), wherein the electrical contact region (11) for a first electrode of the OLED element is arranged within the normal projection of the substrate (10) but outside the normal projection of the encapsulation element (15).

2. Light output device according to claim 1,
wherein the electrical contact region (11), when viewed in the direction normal to the OLED element, is oblong and wherein the electrical conductor element (31, 32, 33) is electrically conductively connected to the contact region (11).

3. Light output device according to claim 1 or 2,
in which the encapsulation element (15), when viewed in the direction normal to the OLED element, is rectangular at least in the first approximation so that it accordingly has four sides *(S1, S2, S3, S4)* and the electrical contact region (11) is designed in such a way that it extends along one of the four sides *(S1)* over at least one fourth, preferably over at least one third, of the length (*l*) of this one side *(S1)*.

4. Light output device according to one of claims 1 to 3, which comprises at least one further contact region (11') for the first electrode, wherein the further contact region (11') is designed in such a way that it extends along one of the four sides (S1) over at least one fourth, preferably over at least one third, of the length (l) of this one side (S1).

5. Light output device according to one of claims 1 to 4, which comprises a second electrical contact region (12) for a second electrode of the OLED element, wherein the second contact region (12) is designed in such a way that it extends along one of the four sides (S1) over at least one fourth, preferably over at least one third, of the length (l) of this one side (S1).

6. Light output device according to one of the preceding claims, in which the electrical conductor element (31, 32, 33) consists of metal or is metalized.

7. Light output device according to one of the preceding claims, in which the electrical conductor element (31, 32, 33) consists of a metal foil or a metal wire or a flexible circuit board.

8. Light output device according to one of the preceding claims, in which the electrical conductor element (31, 32, 33) consists of copper or aluminum or an alloy from or with copper and/or aluminum.

9. Light output device according to one of the preceding claims, wherein at least the electrical conductor element (31, 32, 33) is electrically connected via at least one joint *(K1...K6, T1...T6),* preferably over several joints *(K1...K6, T1...T6),* to the contact region (11) for a first electrode and/or to a carrier contact region (21) formed on the carrier (20).

10. Light output device according to claim 9,
in which at least one joint *(K1... K6, T1...T6)* is formed by soldering or gluing, in particular with an anisotropic adhesive or a conductive adhesive.

11. Light output device according to one of the preceding claims, in which the electrical conductor element (31, 32, 33) is oblong and has a 180° bend in a longitudinal section.

12. Light output device according to one of the preceding claims, in which the electrical conductor element (31) is spiral-shaped.

13. Light output device according to one of the preceding claims, in which the electrical conductor element (33) is wave-shaped.

## Revendications

1. Dispositif émetteur de lumière, comprenant :
- un élément OLED plan sur un substrat (10), l'élément OLED présentant une première électrode disposée sur le substrat (10), une couche organique disposée sur la première électrode et une deuxième électrode disposée sur la couche organique, et
- un élément d'encapsulation (15) destiné à protéger l'élément OLED, l'élément d'encapsulation (15) étant conçu pour s'étendre sur l'électrode qui est opposée au substrat (10) par rapport à la couche organique,
- un support (20) sur lequel l'élément OLED est disposé de sorte que l'élément d'encapsulation (15) est orienté vers le support (20) et
- un élément conducteur électrique (31, 32, 33) permettant un raccordement électrique entre le support (20) et l'élément OLED,
l'élément conducteur électrique (31, 32, 33) étant élastique suivant un sens perpendiculaire à l'élément OLED,
le support (20) présentant une surface (25) qui est orientée vers l'élément OLED et est placée sur des pistes conductrices destinées à l'alimentation électrique de l'élément OLED,
**caractérisé en ce**
**qu'**en considérant de manière perpendiculaire par rapport à l'élément OLED
a) l'élément d'encapsulation (15) présente une plus petite surface que le substrat (10) et se trouve entièrement dans la projection perpendiculaire du substrat (10), et
b) une zone de contact électrique (11), qui est disposée sur le substrat (10) et à côté de l'élément d'encapsulation (15), la zone de contact électrique (11) étant disposée pour une première électrode de l'élément OLED dans la projection perpendiculaire du substrat (10) mais en dehors de la projection perpendiculaire de l'élément d'encapsulation (15).

2. Dispositif émetteur de lumière selon la revendication 1,
la zone de contact électrique (11) étant allongée, considérée de manière perpendiculaire à l'élément OLED et l'élément conducteur électrique (31, 32, 33) étant raccordé de manière électroconductrice à la zone de contact (11).

3. Dispositif émetteur de lumière selon la revendication 1 ou 2, dans lequel l'élément d'encapsulation (15), considérée de manière perpendiculaire à l'élément OLED, est au moins selon une première approximation de forme rectangulaire, de sorte qu'il présente en conséquence quatre côtés *(S1, S2, S3, S4)* et la zone de contact électrique (11) est formée de manière à s'étendre le long d'un des autres côtés CSV), sur au moins un quart, de préférence sur au moins un tiers de la longueur (*l*) dudit un côté *(S1)*.

4. Dispositif émetteur de lumière selon l'une quelconque des revendications 1 à 3,
qui présente au moins une zone de contact supplémentaire (11') pour la première électrode, la zone de contact supplémentaire (11') étant formée de manière à s'étendre le long d'un des quatre côtés (S1) sur au moins un quart, de préférence au moins un tiers de la longueur (1) dudit un côté (S1).

5. Dispositif émetteur de lumière selon l'une quelconque des revendications 1 à 4,
qui présente une deuxième zone de contact électrique (12) pour une deuxième électrode de l'élément OLED, la deuxième zone de contact (12) étant formée de manière à s'étendre le long d'un des quatre côtés (S1) sur au moins un quart, de préférence sur au moins un tiers de la longueur (1) dudit un côté (S1).

6. Dispositif émetteur de lumière selon l'une quelconque des revendications précédentes,
dans lequel l'élément conducteur électrique (31, 32, 33) est composé de métal ou est métallisé.

7. Dispositif émetteur de lumière selon l'une quelconque des revendications précédentes,
dans lequel l'élément conducteur électrique (31, 32, 33) est composé d'une feuille métallique ou d'un fil métallique ou d'un circuit imprimé souple.

8. Dispositif émetteur de lumière selon l'une quelconque des revendications précédentes,
dans lequel l'élément conducteur électrique (31, 32, 33) est composé de cuivre ou d'aluminium ou d'un alliage composé de ou comprenant du cuivre et/ou de l'aluminium.

9. Dispositif émetteur de lumière selon l'une quelconque des revendications précédentes,
dans lequel l'élément conducteur électrique (31, 32, 33) est raccordé électriquement, par le biais d'au moins un point de jonction *(Kl. K6, T1...T6),* de préférence par le biais de plusieurs points de jonction *(K1...K6, T1...T6),* à la zone de contact (11) pour une première électrode et/ou à une zone de contact-support (21) formée sur le support (20).

10. Dispositif émetteur de lumière selon la revendication 9, dans lequel le au moins un point de jonction *(K1...K6, T1...T6)* est formé par des soudures ou des collages, notamment avec un adhésif anisotrope ou un adhésif conducteur.

11. Dispositif émetteur de lumière selon l'une quelconque des revendications précédentes,
dans lequel l'élément conducteur électrique (31, 32, 33) est de forme allongée et présente une flexion à 180° dans une section longitudinale.

12. Dispositif émetteur de lumière selon l'une quelconque des revendications précédentes, dans lequel l'élément conducteur électrique (31) est en forme de spirale.

13. Dispositif émetteur de lumière selon l'une quelconque des revendications précédentes, dans lequel l'élément conducteur électrique (33) est ondulé.
